# EUROPÄISCHE PATENTSCHRIFT

(11) **EP 3 513 469 B1**
(45) Veröffentlichungstag und Bekanntmachung des Hinweises auf die Patenterteilung: **19.06.2024**
(21) Anmeldenummer: 17755498.7
(22) Anmeldetag: 21.08.2017
(51) Int. Cl.: H02B 1/052, H02B 1/26, H02B 1/30, H02B 1/50, H02B 1/54, H05K 5/02, H05K 7/14, B61C 17/00

(54) **ELEKTRISCHE EINHEIT FÜR EIN SCHIENENGEBUNDENES FAHRZEUG**
ELECTRICAL UNIT FOR A RAIL-BOUND VEHICLE
UNITÉ ÉLECTRIQUE CONÇUE POUR UN VÉHICULE SUR RAILS

(30) Priorität: 16.09.2016 DE 102016117501
(43) Veröffentlichungstag der Anmeldung: 24.07.2019
(73) Patentinhaber: KNORR-BREMSE Systeme für Schienenfahrzeuge GmbH, 80809 München (DE)
(72) Erfinder: MANN, Hartmut, 85232 Bergkirchen (DE); WACH, Jörg-Johannes, 81247 München (DE); LAMPRECHT, Marcus, 85375 Neufahrn (DE); MÜNCH, Lothar, 85649 Hofolding (DE)
(74) Vertreter: Prüfer & Partner mbB Patentanwälte · Rechtsanwälte
(86) Internationale Anmeldenummer: PCT/EP2017/071054
(87) Internationale Veröffentlichungsnummer: WO 2018/050399

(56) Entgegenhaltungen:
- CN-U- 203 020 314
- DE-A1-102010 007 589
- DE-A1-102013 110 637
- DE-A1-102013 113 472

## Beschreibung

Die vorliegende Erfindung bezieht sich auf eine elektrische Einheit für ein schienengebundenes Fahrzeug.

Die elektrische Einheit hat die Aufgabe, bestimmte Steuerungsfunktionen für das schienengebundene Fahrzeug zu übernehmen, und sie enthält unter anderem eine elektromechanische Baugruppe mit Recheneinheiten wie zum Beispiel eine 19" Steuereinheit, Relais (Schützen) für Zugfunktionen und einer standardisierten elektrischen Schnittstelle. Für die elektrische Einheit gibt es in verschiedenen Ländern unterschiedliche internationale Standards, die jeweils durch individuell angepasste Einzellösungen erfüllt werden müssen. Zum Beispiel enthält die elektromechanische Baugruppe für den chinesischen Markt eine Steuereinheit (Gleitschutz) im 19-Zoll Format, zwölf Relais (Schütze) für Zugfunktionen und eine standardisierte elektrische Schnittstelle. Demgegenüber enthält die elektromechanische Baugruppe nach dem UIC-Standard zwei Recheneinheiten im 19-Zoll Format, zwei Recheneinheiten im halben 19-Zoll Format und eine standardisierte elektrische Schnittstelle.

Jeder dieser elektrischen Einheiten wird zusammen mit weiteren Bauelementen des schienengebundenen Fahrzeugs in einem Gehäuse untergebracht. Dabei werden die einzelnen Komponenten (Steuereinheiten, Verdrahtungseinheit usw.) individuell konstruiert und in einem geschweißten und lackierten Gehäuse unter Verwendung von Edelstahlblechen verbaut. Je nach Projekt und Einbausituation ergibt sich daraus eine eigene Gehäusekonstruktion.

Daneben gibt es unterschiedliche internationale Sicherheitsstandards wie zum Beispiel bei Schweißverbindungen, die ggf. einem Zulassungstest ausgesetzt werden müssen.

Der Einsatz in einem schienengebundenen Fahrzeug bringt auch vielfältige Anforderungen hinsichtlich der Stoß- und Schwingfestigkeit mit sich, insbesondere bei schlechten Gleisanlagen, ungenügenden Wagenkastenkonstruktionen, etc.

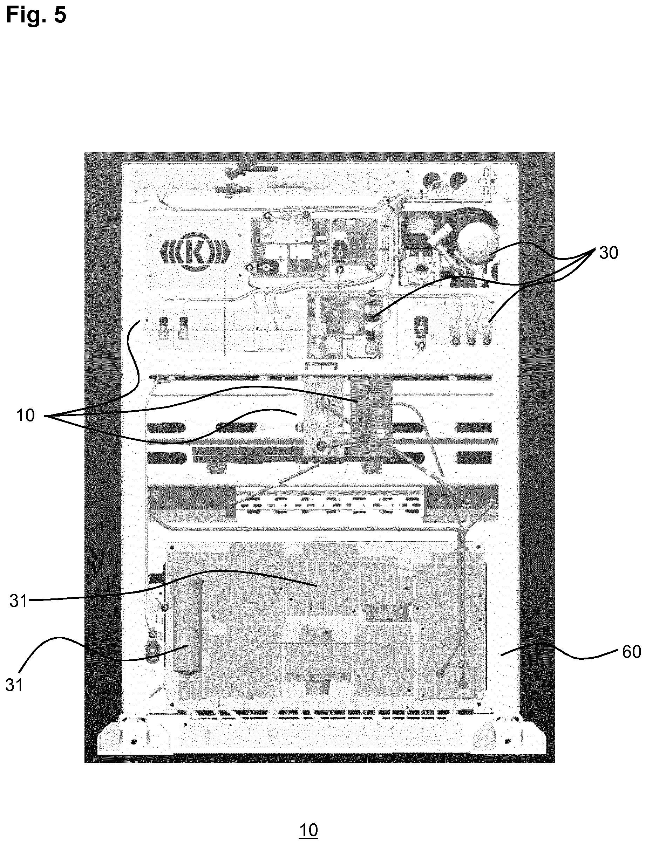

**Fig. 5** zeigt als ein konkretes Beispiel des Stands der Technik eine herkömmliche Integration mehrerer elektrischer Einheiten 10 in einer Lok. Diese elektrischen Einheiten 10 haben ein geschweißtes Gerüst 60 mit verschiedenen elektrischen, elektromechanischen sowie pneumatischen Komponenten 30. In dem Gerüst 60 befinden sich unter den elektromechanischen Baugruppen 30 weitere Bauelemente 31, die in der Regel länderspezifischen Vorgaben unterliegen.

Die DE 10 2013 110 637 offenbart in diesem Zusammenhang ein Aufnahme- und Tragssystem mit einem Aufnahmebehälter zur Aufnahme von Elektronikkomponenten und einer Tragevorrichtung zur Anbringung des Aufnahmebehälters an einem Schienenfahrzeug, wobei die Tragevorrichtung eines oder mehrere Trageelemente aufweist, das oder die zumindest in einer Richtung an wenigstens einer an dem Aufnahmebehälter abgeordneten Tragschiene bei ihrer Erstmontage am Tragsystem frei positionierbar ist oder sind.

Die DE 10 2013 113 472 A1 ist auf ein Aufnahme- und Tragsystem gerichtet, das eigene Aufnahmebehälter zur Aufnahme von Elektronikkomponenten sowie eine Tragevorrichtung zur Anbringung des Aufnahmebehälters an einem Schienenfahrzeug umfasst, wobei der Aufnahmebehälter aus zwei oder mehreren zusammengefügten Modulen gebildet ist.

Die CN 203 020 314 U betrifft eine elektromechanische Zerhackervorrichtung mit einem Dämpfer, wobei die Zerhackervorrichtung mit einer Karosserie eines Schienenfahrzeugs verbunden wird.

Die DE 10 2010 007589 A1 offenbart eine Anordnung mit einem Wagenkasten und einem elektrischen Schalter. Um eine Übertragung von Schaltgeräuschen des elektrischen Schalters in das Innere des Wagenkastens zu reduzieren beziehungsweise zumindest weitgehend zu vermeiden, ist der elektrische Schalter elastisch an den Wagenkasten angebunden.

Es ist die Aufgabe der vorliegenden Erfindung, eine elektrische Einheit vorzusehen, die kostengünstiger und unter geringerem Entwicklungsaufwand herzustellen ist.

Diese Aufgabe wird durch die elektrische Einheit gemäß Anspruch 1 gelöst. Vorteilhafte Weiterbildungen ergeben sich aus den abhängigen Ansprüchen.

Die elektrische Einheit für ein schienengebundenes Fahrzeug weist eine elektromechanische Baugruppe mit elektrischen oder elektromechanischen Komponenten auf. Eine universelle mechanische Schnittstelle, die auf einem Unterbau des schienengebundenen Fahrzeugs, der eine Gerüststruktur aufweist, aufsetzbar und separat und trennbar vom Gehäuse ausgebildet ist, ist an der elektromechanischen Baugruppe angebracht. Ein Gehäuse nimmt zumindest die elektromechanische Baugruppe auf und ist getrennt vom Unterbau ausgebildet. Zudem ist zumindest ein Dämpfer an der mechanischen Schnittstelle vorgesehen, wobei der Dämpfer zwischen dem Gehäuse und der mechanischen Schnittstelle dämpft oder geeignet ist, zwischen der mechanischen Schnittstelle und dem Unterbau des schienengebundenen Fahrzeugs zu dämpfen. Die mechanische Schnittstelle weist zumindest eine Profilschiene auf, die mit dem zumindest einen Dämpfer in Kontakt ist. Die elektromechanische Baugruppe und die mechanische Schnittstelle (4) sind über den Dämpfer aneinander geschraubt oder genietet. In vorteilhafter Weise wird so ein standardisiertes Grundkonzept verwirklicht, welches den Austausch ermöglicht (zum Beispiel UIC-Standard durch projektspezifische Ausführungen).

Das Gehäuse ist eigensteif unabhängig von der restlichen Gerüststruktur des Unterbaus. Die Gerüststruktur des Unterbaus kann niedriger bzw. kleiner ausgeführt werden, da die elektrische Einheit oben aufgesetzt wird. Dadurch wird eine Kosteneinsparung des Gerüsts für den Unterbau verwirklicht.

Die modulare Gestaltung ermöglicht ferner eine Optimierung des Entwicklungsaufwandes sowie insgesamt eine Kostenreduzierung, insbesondere wenn die elektromechanische Baugruppe und die mechanische Schnittstelle aneinander geschraubt oder genietet sind. Dadurch fallen einige herkömmliche Herstellungsschritte weg, wie zum Beispiel das Schweißen von Edelstahlblechen einschließlich dessen Abnahme- und Zertifizierungskosten. Die Montage wird zudem unabhängig von einem bestimmten Fertigungsstandort und kann direkt vor Ort erfolgen. Durch das Wegfallen der Schweißarbeiten können auch Aluminiumbleche anstelle der herkömmlichen Edelstahlbleche verwendet werden. Damit kann auch das herkömmliche Lackieren der Edelstahlbleche wegfallen.

Weitere Vorteile der Erfindung sind die Wiederverwendbarkeit von einzelnen Bauteilen, eine Gewichtsreduzierung und eine Reduzierung der Teilezahl. Da Dämpfer verwendet werden, kann zudem eine Schwingungsentkopplung bewirkt werden.

Im Folgenden wird ein Ausführungsbeispiel der vorliegenden Erfindung anhand der Figuren beschrieben. Es zeigen:
- Fig. 1: eine perspektivische Ansicht einer elektrischen Einheit gemäß einem Ausführungsbeispiel der vorliegenden Erfindung, die auf einem Unterbau eines schienengebundenen Fahrzeugs aufgesetzt ist;
- Fig. 2: ein erstes Beispiel einer elektromechanischen Baugruppe der elektrischen Einheit;
- Fig. 3: ein zweites Beispiel einer elektromechanische Baugruppe der elektrischen Einheit;
- Fig. 4: ein Beispiel einer universellen mechanischen Schnittstelle der elektrischen Einheit; und
- Fig. 5: eine elektrischen Einheit aus dem Stand der Technik.

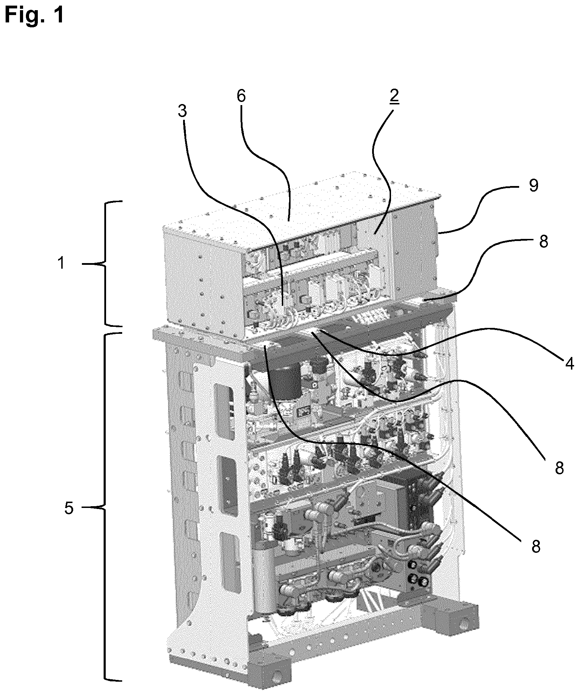

Fig. 1 zeigt gemäß einem Ausführungsbeispiel der vorliegenden Erfindung eine perspektivische Ansicht einer elektrischen Einheit 1 für ein schienengebundenes Fahrzeug (nicht gezeigt), die auf einem Unterbau 5 des schienengebundenen Fahrzeugs aufgesetzt ist. Die elektrische Einheit 1 weist eine elektromechanische Baugruppe 2 mit elektrischen oder elektromechanischen Komponenten 3 auf. Dabei kann es sich um Recheneinheiten wie zum Beispiel 19" Steuereinheiten, Relais (Schützen) für Zugfunktionen und einer standardisierten elektrischen Schnittstelle handeln. In vorteilhafter Weise können mehrere elektrische Einheiten 10 aus dem Stand der Technik (siehe Fig. 5) funktional und räumlich einer einzigen elektrischen Einheit 1 der vorliegenden Erfindung zusammengefasst bzw. vereinigt werden.

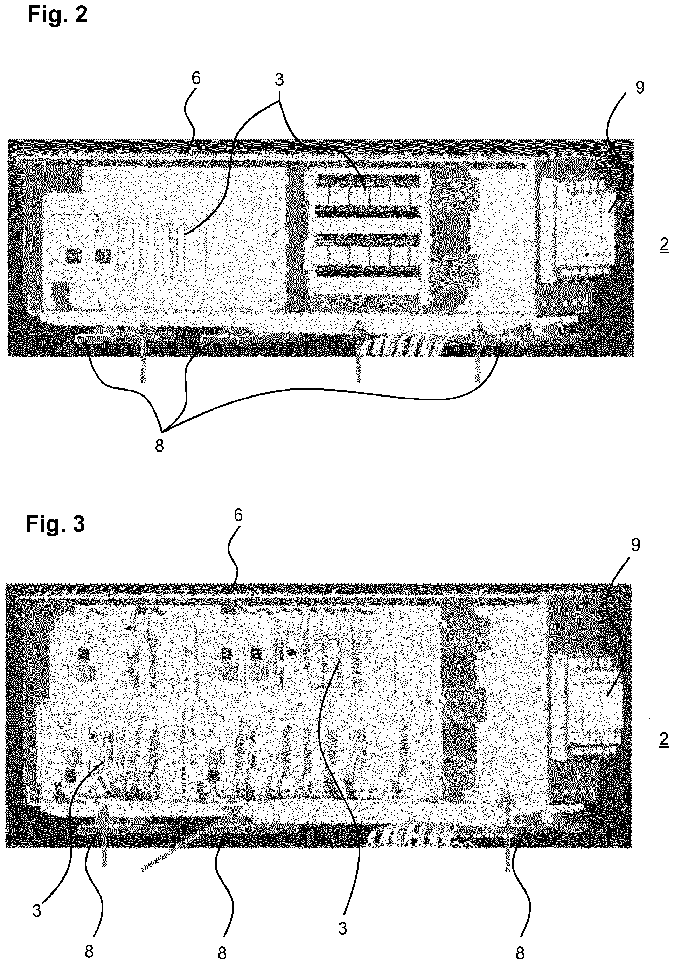

**Figuren 2 und 3** zeigen ein erstes bzw. ein zweites Beispiel einer elektromechanischen Baugruppe 2 der elektrischen Einheit 1. Die Fig. 2 zeigt eine elektromechanische Baugruppe 2 nach dem UIC-Standard, während die Fig. 3 eine elektromechanische Baugruppe 2 nach einer projektspezifischen Ausführung zeigt.

Die elektromechanische Baugruppe 2 der elektrischen Einheit 1 hat ein Gehäuse 6, das zumindest die elektrischen oder elektromechanischen Komponenten 3 aufnimmt und getrennt vom Unterbau 5 ausgebildet ist. Das Gehäuse 6 ist ausreichend steif (eigensteifes Gehäuse 6) und kann somit unabhängig von der restlichen Gerüststruktur des Unterbaus 5 vorgesehen werden. Ferner kann die restliche Gerüststruktur des Unterbaus 5 niedriger bzw. kleiner als im Stand der Technik ausgeführt werden, da die elektromechanische Baugruppe 2 separat ausgebildet ist und in einfacher Weise oben aufgesetzt wird. Darüber hinaus führt dies zu einem Kostenvorteil für die restliche Gerüststruktur des Unterbaus 5 im Vergleich mit dem Stand der Technik.

Gemäß der vorliegenden Erfindung hat die elektrische Einheit 1 eine am Gehäuse 6 angebrachte, universelle mechanische Schnittstelle 4, die auf dem Unterbau 5 des schienengebundenen Fahrzeugs aufsetzbar ist. Im dargestellten Ausführungsbeispiel ist die mechanische Schnittstelle 4 an den Unterbau 5 geschraubt. Alternativ kann sie daran genietet sein.

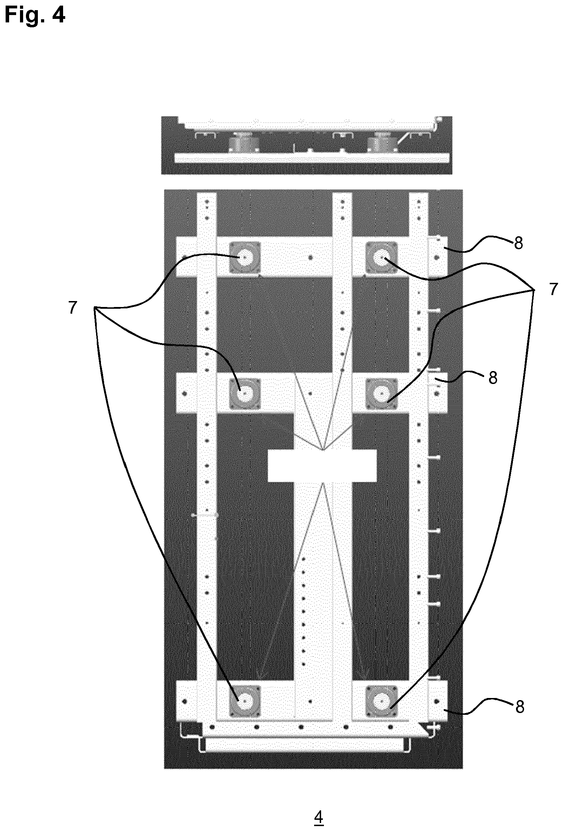

**Fig. 4** zeigt ein Beispiel einer mechanischen Schnittstelle 4. An der mechanischen Schnittstelle 4 ist zumindest ein Dämpfer 7 vorgesehen. Im vorliegenden Ausführungsbeispiel sind sechs Dämpfer 7 vorgesehen. Die Dämpfer 7 sorgen für eine Entkoppelung von Vibrationen aus dem Fahrzeug. Im dargestellten Ausführungsbeispiel sind die Dämpfer 7 zwischen der elektromechanischen Baugruppe 2 und der mechanischen Schnittstelle 4 angeordnet, um dazwischen eine Dämpfung zu bewirken. Alternativ können die Dämpfer 7 zwischen der mechanischen Schnittstelle 4 und dem Unterbau 5 des schienengebundenen Fahrzeugs vorgesehen sein, um dazwischen eine Dämpfung zu bewirken. Im dargestellten Ausführungsbeispiel weist die mechanische Schnittstelle 4 zumindest eine Profilschiene 8 auf, die mit dem zumindest einem Dämpfer 7 in Kontakt ist. Dadurch kann die elektromechanische Baugruppe 2 einfach auf die mechanische Schnittstelle 4 aufgesetzt und an dieser ausgerichtet werden.

Im dargestellten Ausführungsbeispiel ist die mechanische Schnittstelle 4 separat und trennbar von der elektromechanischen Baugruppe 2 ausgebildet. Vorzugsweise sind die elektromechanische Baugruppe 2 und die mechanische Schnittstelle 4 aneinander geschraubt oder genietet. Sofern Dämpfer 7 vorgesehen sind, können die elektromechanische Baugruppe 2 und die mechanische Schnittstelle 4 über die Dämpfer 7 aneinander geschraubt oder genietet sein. Durch die Verschraubung/Vernietung ist es möglich, unterschiedliche elektromechanische Baugruppen 2 mit unterschiedlichen elektrischen oder elektromechanischen Komponenten 3 jeweils an die eine universelle mechanische Schnittstelle 4 anzubringen. Vorzugsweise haben dabei die unterschiedlichen elektromechanischen Baugruppen 2 jeweils eine standardisierte elektrische Schnittstelle 9.

Dadurch wird ein standardisiertes Grundkonzept verwirklicht, welches einen einfachen und kostengünstigen Austausch verschiedener Varianten der elektromechanische Baugruppe 2 ermöglicht, wie zum Beispiel einen Austausch der UIC-Variante durch eine projektspezifische Variante und umgekehrt. Auch die Teilezahl wird reduziert, da lediglich der Oberbau in Gestalt der elektrischen Einheit 1 individuell gestaltet ist, während der Unterbau 5 beibehalten werden kann. Insgesamt kann der Entwicklungsaufwand optimiert werden, und eine Kostenreduzierung kann erzielt werden.

Vorzugsweise besteht das Gehäuse 6 aus Aluminium mit passivierter elektrisch leitender Beschichtung. Edelstahlbleche, wie sie im Stand der Technik verwendet werden, sind bei der vorliegenden Erfindung nicht zwingend erforderlich, da die Bleche nicht verschweißt werden. Darüber hinaus ist kein Lackieren erforderlich. Dadurch fallen Fertigungsschritte des Schweißens einschließlich dessen Abnahme- und Zertifizierungskosten und des Lackierens weg. Die Montage wird dadurch unabhängig von einem bestimmten Fertigungsstandort und kann direkt vor Ort erfolgen. Darüber hinaus sind bei der vorliegenden Erfindung einzelne Bauteile wiederverwendbar bzw. recyclebar. Ferner wird eine Gewichtsreduzierung erreicht, da Aluminium anstelle von Edelstahl verwendet wird.

Vorzugsweise weist die elektromechanische Baugruppe 2 zumindest eine Recheneinheit im 19 Zoll-Format auf. Dadurch kann eine weitere Standardisierung erreicht werden.

Die vorliegende Erfindung ist nicht auf die dargestellten Ausführungsbeispiele beschränkt, sondern umfasst Änderungen und Abwandlungen innerhalb des Umfangs der beigefügten Ansprüche.

### BEZUGSZEICHENLISTE

- 1: Elektrische Einheit
- 2: elektromechanische Baugruppe
- 3: elektrische oder elektromechanische Komponente
- 4: mechanische Schnittstelle
- 5: Unterbau des schienengebundenen Fahrzeugs
- 6: Gehäuse
- 7: Dämpfer
- 8: Profilschiene
- 9: standardisierte elektrische Schnittstelle

## Patentansprüche

1. Elektrische Einheit (1) für ein schienengebundenes Fahrzeug, die eine elektromechanische Baugruppe (2) mit elektrischen oder elektromechanischen Komponenten (3) aufweist, wobei die elektromechanische Baugruppe (2) ein Gehäuse (6) aufweist, das zumindest die elektrischen oder elektromechanischen Komponenten (3) aufnimmt,
**gekennzeichnet durch**
eine an dem Gehäuse (6) angebrachte, universelle mechanische Schnittstelle (4), die auf einem Unterbau (5) des schienengebundenen Fahrzeugs, der eine Gerüststruktur aufweist, aufsetzbar und separat und trennbar vom Gehäuse (6) ausgebildet ist, wobei
das Gehäuse (6) getrennt vom Unterbau (5) ausgebildet ist,
wobei zumindest ein Dämpfer (7) an der mechanischen Schnittstelle (4) vorgesehen ist,
wobei der Dämpfer (7) zwischen dem Gehäuse (6) und der mechanischen Schnittstelle (4) dämpft oder geeignet ist, zwischen der mechanischen Schnittstelle (4) und dem Unterbau (5) des schienengebundenen Fahrzeugs zu dämpfen,
wobei die mechanische Schnittstelle (4) zumindest eine Profilschiene (8) aufweist, die mit dem zumindest einen Dämpfer (7) in Kontakt ist, und
wobei die elektromechanische Baugruppe (2) und die mechanische Schnittstelle (4) über den Dämpfer (7) aneinander geschraubt oder genietet sind.

2. Elektrische Einheit (1) gemäß Anspruch 1, wobei unterschiedliche elektromechanischen Baugruppen (2) mit unterschiedlichen elektrischen oder elektromechanischen Komponenten (3) jeweils an die eine universelle mechanische Schnittstelle (4) anbringbar sind.

3. Elektrische Einheit (1) gemäß Anspruch 2, wobei die unterschiedlichen elektromechanischen Baugruppen (2) jeweils eine standardisierte elektrische Schnittstelle (8) aufweisen.

4. Elektrische Einheit (1) gemäß einem der vorherigen Ansprüche, wobei das Gehäuse (6) aus Aluminium besteht.

5. System bestehend aus einer elektrischen Einheit (1) gemäß einem der vorherigen Ansprüche und einem Unterbau (5) des schienengebundenen Fahrzeugs, wobei die mechanische Schnittstelle (4) an den Unterbau (5) geschraubt oder genietet ist.

6. System gemäß Anspruch 5, wobei die elektromechanische Baugruppe (2) eine erste elektromechanische Baugruppe (2) ist,
des Weiteren mit einer zweiten elektromechanischen Baugruppe (2), die andere elektrische oder elektromechanische Komponenten (3) als die erste elektromechanische Baugruppe (2) hat, wobei die erste und die zweite elektromechanische Baugruppe (2) jeweils an die eine universelle mechanische Schnittstelle (4) anbringbar sind.

## Claims

1. Electrical unit (1) for a rail-bound vehicle having an electromechanical assembly (2) with electrical or electromechanical components (3), wherein the electromechanical assembly (2) has a housing (6) which accommodates at least the electrical or electromechanical components (3),
**characterized by**
a universal mechanical interface (4) attached to the housing (6), which interface can be placed on a substructure (5) of the rail-bound vehicle, which has a framework structure, and is configured separately and to be separable from the housing (6), wherein
the housing (6) is configured to be separate from the substructure (5),
wherein at least one damper (7) is provided at the mechanical interface (4),
wherein the damper (7) provides damping between the housing (6) and the mechanical interface (4) or is suitable for damping between the mechanical interface (4) and the substructure (5) of the rail-bound vehicle,
wherein the mechanical interface (4) has at least one profile rail (8) which is in contact with the at least one damper (7) and
wherein the electromechanical assembly (2) and the mechanical interface (4) are screwed or riveted together via the damper (7).

2. Electrical unit (1) according to claim 1, wherein different electromechanical assemblies (2) with different electrical or electromechanical components (3) can be attached respectively to the one universal mechanical interface (4).

3. Electrical unit (1) according to claim 2, wherein the different electromechanical assemblies (2) each have a standardized electrical interface (8).

4. Electrical unit (1) according to any one of the preceding claims, wherein the housing (6) is made of aluminum.

5. System consisting of an electrical unit (1) according to any one of the preceding claims and a substructure (5) of the rail-bound vehicle, wherein the mechanical interface (4) is screwed or riveted to the substructure (5).

6. System according to claim 5, wherein the electromechanical assembly (2) is a first electromechanical assembly (2),
further comprising a second electromechanical assembly (2), which has different electrical or electromechanical components (3) than the first electromechanical assembly (2), wherein the first and the second electromechanical assembly (2) can be attached respectively to the one universal mechanical interface (4).

## Revendications

1. Unité électrique (1) pour un véhicule sur rails qui présente un ensemble électromécanique (2) avec des composants électriques ou électromécaniques (3), dans laquelle l'ensemble électromécanique (2) présente un boîtier (6) qui reçoit au moins les composants électriques ou électromécaniques (3),
**caractérisée par**
une interface mécanique universelle (4) placée au niveau du boîtier (6) qui peut être posée sur un soubassement (5) du véhicule sur rails qui présente une structure d'ossature et est conçue séparément et de manière séparable du boîtier (6), dans laquelle
le boîtier (6) est conçu séparément du soubassement (5),
dans laquelle au moins un amortisseur (7) est prévu au niveau de l'interface mécanique (4),
dans laquelle l'amortisseur (7) amortit entre le boîtier (6) et l'interface mécanique (4) ou est adapté pour amortir entre l'interface mécanique (4) et le soubassement (5) du véhicule sur rails,
dans laquelle l'interface mécanique (4) présente au moins un rail profilé (8) qui est en contact avec le au moins un amortisseur (7), et
dans laquelle l'ensemble électromécanique (2) et l'interface mécanique (4) sont vissés ou rivetés l'un à l'autre par l'intermédiaire de l'amortisseur (7).

2. Unité électrique (1) selon la revendication 1, dans laquelle différents ensembles électromécaniques (2) avec différents composants électriques ou électromécaniques (3) peuvent être appliqués respectivement au niveau de l'une interface mécanique universelle (4).

3. Unité électrique (1) selon la revendication 2, dans laquelle les différents ensembles électromécaniques (2) présentent respectivement une interface électrique standardisée (8).

4. Unité électrique (1) selon l'une quelconque des revendications précédentes, dans laquelle le boîtier (6) se compose d'aluminium.

5. Système consistant en une unité électrique (1) selon l'une quelconque des revendications précédentes et un soubassement (5) du véhicule sur rails, dans lequel l'interface mécanique (4) est vissée ou rivetée au soubassement (5).

6. Système selon la revendication 5, dans lequel l'ensemble électromécanique (2) est un premier ensemble électromécanique (2),
en outre avec un second ensemble électromécanique (2) qui présente des composants électriques ou électromécaniques (3) différents de ceux du premier ensemble électromécanique (2), dans lequel les premier et second ensembles électromécaniques (2) peuvent être appliqués respectivement au niveau de l'une interface mécanique universelle (4).
